Europäisches Patentamt

European Patent Office

Office européen des brevets

(19)

(11) Veröffentlichungsnummer: **0 178 425**
**A1**

# (12) EUROPÄISCHE PATENTANMELDUNG

(21) Anmeldenummer: 85110470.3

(22) Anmeldetag: 20.08.85

(51) Int. Cl.4: **G01R 31/28** , G01R 31/30

(30) Priorität: 13.09.84 DE 3433650

(43) Veröffentlichungstag der Anmeldung:
23.04.86 **Patentblatt 86/17**

(84) Benannte Vertragsstaaten:
**DE FR GB NL**

(71) Anmelder: **Siemens Aktiengesellschaft**
**Berlin und München Wittelsbacherplatz 2**
**D-8000 München 2(DE)**

(72) Erfinder: **Feuerbaum, Hans-Peter, Dr. Dipl.-Phys.**
**Arno-Assmann-Strasse 14**
**D-8000 München 83(DE)**

(54) Verfahren und Vorrichtung zur Fehlerlokalisierung einer elektrischen Schaltung mit einem Lichtstrahl.

(57) Mit einem Verfahren und mit einer Vorrichtung zur Fehlerlokalisierung in einer elektrischen Schaltung (14) mit einem Lichtstrahl (L), bei denen wenigstens ein Abtastpunkt innerhalb der elektrischen Schaltung (14) mit einem sich wiederholenden Spannungsverlauf angesteuert wird, bei denen der Lichtstrahl (L) beim Abtasten eines Abtastpunkts durch Freisetzen von Ladungsträgern die Funktion der elektrischen Schaltung (14) stört, bei denen bei jedem Abtastpunkt die Spannung, mit der dieser Abtastpunkt angesteuert wird, verändert oder konstantgehalten wird, sollen diejenigen Schwachstellen lokalisiert werden können, die Ursache dafür sind, daß die elektrische Schaltung (14) eine gewünschte Spezifikation nicht erreicht. Bei jedem Abtasten eines jeden Abtastpunkts wird wenigstens eine einzige Periode des sich wiederholenden Spannungsverlaufs durchlaufen. Bei jedem Abtastpunkt wird wenigstens ein für die gewünschte Spezifikation der elektrischen Schaltung (14) kritischer Parameter (P) moduliert, und zwar solange, bis die elektrische Schaltung (14) funktionsuntüchtig ist.

FIG 6

Die Erfindung betrifft ein Verfahren und eine Vorrichtung zur Fehlerlokalisierung in einer elektrischen Schaltung mit einem Lichtstrahl nach dem Oberbegriff des Anspruchs 1 bzw. nach dem Oberbegriff des Anspruchs 13.

Bei der Fehleranalyse von integrierten Schaltungen muß zwischen Fehlerursachen unterschieden werden, die entwerder in einem fehlerhaften Design begründet sind oder auf technologische Mängel zurückgeführt werden können. Die Elektronenstrahl-Meßtechnik arbeitet schwerpunktmäßig an der Designoptimierung. Ein Verfahren und eine Vorrichtung zur Potentialmessung an einem elektronischen Bauelement mit Hilfe der Elektronenstrahl-Meßtechnik ist beispielsweise in der US-Patentschrift 4277679 beschrieben. Die Elektronenstrahl-Meßtechnik ist zur Lokalisierung von technologischen Fehlern weniger geeignet als zur Lokalisierung von Fehlern im Design eines elektronischen Bauelementes.

Zur Fehlerlokalisierung im Innern von integrierten Schaltungen wird das sogenannte "marginal voltage testing" verwendet (Microelectronics and Reliability, Vol.22, No.2, pp. 241-264, 1982, GB). Bei diesem Verfahren zur Fehlerlokalisierung wird die integrierte Schaltung mit einer hochfrequenten Spannung angesteuert, bei der sich Spannungspulse periodisch wiederholen. Außerdem wird die integrierte Schaltung mit einem fokussierten Laserstrahl zeilenweise abgetastet. Durch Frei setzen von Ladungsträgern in demjenigen Bereich, in dem der Laserstrahl auf die integrierte Schaltung auftrifft, stört der Laserstrahl die elektrische Funktion der integrierten Schaltung. Trifft der Laserstrahl auf eine Stelle im Innern der integrierten Schaltung, die Design- und/oder Technologiefehler aufweist, so kann die durch den Laserstrahl verursachte Störung zum Ausfall der logischen Funktion der elektrischen Schaltung führen. Die Wahrscheinlichkeit für den Ausfall der logischen Funktion der elektrischen Schaltung steigt mit sinkender Betriebsspannung, mit der die integrierte Schaltung betrieben wird. Aus diesem Grund wird bei dem bekannten Stand der Technik bei jedem Abstastpunkt, auf den der Laserstrahl auftrifft, die Betriebsspannung der integrierten Schaltung solange erniedrigt, bis die elektrische Schaltung funktionsuntüchtig ist. Die kleinste mögliche Betriebsspannung, bei der die elektrische Schaltung noch funktioniert, obwohl der Laserstrahl auf einen Abtastpunkt innerhalb der integrierten Schaltung auftrifft, ist daher ein Maß für die Schwere des an einem Abtastpunkt gefundenen Fehlers. Je größer die mögliche Betriebsspannung ist, bei der die elektrische Schaltung gerade noch funktioniert, wobei die elektrische Schaltung bei weitergehender Erniedrigung dieser Betriebsspannung gerade nicht mehr funktioniert, desto schwerwiegender ist der an einem Abtastpunkt gefundene Fehler.

Der vorliegenden Erfindung liegt die Aufgabe zugrunde, ein Verfahren und eine Vorrichtung der eingangs genannten Art anzugeben, mit denen diejenigen Schwachstellen lokalisiert werden können, die Ursache dafür sind, daß die elektrische Schaltung eine gewünschte Spezifikation nicht erreicht.

Diese Aufgabe wird erfindungsgemäß durch ein Verfahren nach dem Anspruch 1 und durch eine Vorrichtung nach dem Anspruch 13 gelöst. Ausgestaltungen und Vorteile der Erfindung sind in den Unteransprüchen, der Beschreibung und der Zeichnung dargestellt.

Die integrierte Schaltung wird vorteilhafterweise von einem fokussierten Laserstrahl abgetastet. Der fokussierte Laserstrahl setzt im Innern der integrierten Schaltung an den Abtastpunkten Ladungsträger frei, die die elektrische Funktion der integrierten Schaltung stören. Gemäß der Erfindung werden den die für die Erreichung einer bestimmten Spezifikation kritischen Parameter einzeln oder in Kombination so moduliert, daß an jedem Abtastpunkt, auf den der Laserstrahl auftrifft, ein an diesem Abtastpunkt sich wiederholender Spannungsverlauf wenigstens einmal vollständig durchlaufen wird, wobei während eines einmaligen Durchlaufs dieses sich wiederholenden Spannungsverlaufs der kritische Parameter vorteilhafterweise praktisch nicht verändert wird. Um eine Messung beschleunigen zu können, sollte die Modulation eines kritischen Parameters über einen bestimmten Modulationsbereich hinweg so rasch wie möglich erfolgen. Aus diesem Grund kann der kritische Parameter auch während eines einmaligen Durchlaufs des sich wiederholenden Spannungsverlaufs verändert werden, sofern diese Veränderung so klein ist, daß die Schwere des Fehlers an einem bestimmten Abtastpunkt einem bestimmten Bereich eines kritischen Parameters zugeordnet werden kann. Solange eine Schwachstelle hinreichend genau lokalisiert werden kann, kann ein kritischer Parameter oder können mehrere kritische Parameter in Kombination auch währed des einmaligen Durchlaufens des ganzen Spannungsverlaufs verändert werden. Bei der Modulation eines oder mehrerer kritischer Parameter kann die Betriebsspannung konstant bleiben oder zusätzlich verändert werden.

Die Fehlerlokalisierung kann so erfolgen, daß der Laser strahl auf einen einzigen Abtastpunkt gerichtet wird und daß er auf diesem Abtastpunkt solange positioniert bleibt, bis ein kritischer Parameter oder bis mehrere kritische Parameter in Kombination über jeweils einen bestimmten Modulationsbereich hinweg verändert worden sind. Die Fehlerlokalisierung kann jedoch auch so erfolgen,

- daß die kritischen Parameter jeweils feste Werte zugeordnet bekommen,
- daß mit dem Laserstrahl sodann die integrierte Schaltung abgerastert wird,
- daß sodann ein kritischer Parameter oder mehrere kritische Parameter in Kombination verändert werden,
- daß mit dem Laserstrahl erneut die integrierte Schaltung abgerastert wird,
- daß die kritischen Parameter solange verändert werden und daß immer wieder von neuem mit dem Laserstrahl die integrierte Schaltung abgerastert wird, bis bei einer bestimmten Kombination von kritischen Parametern bzw. bei einem bestimmten eines kritischen Parameters eine Fehlfunktion der Schaltung auftritt und über den vom Laserstrahl gerade abgetasteten Abtastpunkt der Fehlerort lokalisiert ist.

Wenn der Fehler so lokalisiert werden soll, daß die kritischen Parameter bzw. ein kritischer Parameter einen festen Wert erhalten und daß mit dem Laserstrahl sodann die integrierte Schaltung oder ein Teil einer integrierten Schaltung abgerastert wird, so soll sichergestellt sein, daß bei diesem Abrastern an jedem Abtastpunkt des Laserstrahls ein an diesem Abtastpunkt vorhandener Spannungsverlauf wenigstens einmal durchlaufen wird.

Zum Aufdecken von Fehlern, die den zeitlichen Ablauf von logischen Zuständen betreffen, können bei pulsförmigen Signalverläufen an den jeweiligen Abtastpunkten des Laser strahls folgende kritische Parameter moduliert werden:
- Wiederholrate der Pulse des Spannungsverlaufs,
- Abfall- und Anstiegszeit der Pulse des Spannungsverlaufs,
- Amplituden der Pulse des Spannungsverlaufs,
- eine den Pulsen des Spannungsverlaufs überlagerte Gleichspannung,
- die Phasen der Pulse des Spannungsverlaufs u.s.w.

Zur Lokalisierung von Fehlern, die temperaturabhängig sind oder die nur in elektrischen oder magnetischen Feldern auftreten, kann die Temperatur bzw. können die elektrische und/oder magnetische Feldstärke moduliert werden. Durch Modulation von Strahlung, die auf bestimmte Gebiete trifft, können auch solche Gebiete lokalisiert werden, die empfindlich auf Strahlungen reagieren. Als Strahlung kommen hier UV-Strahlung, Röntgen-Strahlung, Alpha-Strahlung u.s.w. in Frage.

Die Bewertung, inwieweit eine elektrische Schaltung funktionstüchtig ist, erfolgt zweckmäßigerweise über das Ausgangssignal der untersuchten elektrischen Schaltung. Es ist jedoch auch denkbar, daß bei Fertigungstests einzelne elektrische Schaltungen einem Verfahren nach der Erfindung unterzogen werden, daß dabei einige Parameter über einen bestimmten Modulationsbereich hinweg moduliert werden, daß Signale die Aussagen über die logische Funktion von Abtastpunkten während oder nach der Modulation von Parametern enthalten, in irgendeiner Form innerhalb der elektrischen Schaltung gespeichert werden, und daß schließlich ein aus diesen Signlen gebildetes Endsignal aus der elektrischen Schaltung abgerufen werden kann, das eine Aussage darüber enthält, ob die getestete Schaltung bestimmte Spezifikationen erfüllt oder nicht.

Ein Verfahren nach der Erfindung kann beispielsweise auch noch so ausgeführt werden,

- daß mit dem Laserstrahl eine elektrische Schaltung wenigstens teilweise abgerastert wird, und

- daß bei jedem Abtastpunkt ein kritischer Parameter oder mehrere kritische Parameter innerhalb eines bestimmten Modulationsbereiches verändert werden,

- daß dabei geprüft wird, ob dann, wenn diese kritischen Parameter Werte innerhalb dieser Modulationsbereiche aufweisen, ein Fehler auftritt, und

- daß schließlich beim nächsten Abrastern der elektrischen Schaltung die kritischen Parameter so moduliert werden, daß wenigstens ein kritischer Parameter innerhalb eines anderen Modulationsbereiches verändert wird.

Die Modulationsbereiche oder das Verweilen des Laserstrahls an einem bestimmten Abtastpunkt über eine bestimmte Anzahl von Durchläufen des Spannungsverlaufs müssen dabei so gewählt werden, daß eine Fehlerursache an einem bestimmten Abtastpunkt einem bestimmten Wertebereich von kritischen Parametern zugeordnet werden kann.

Ausführungsbeispiele der Erfindung sind im folgenden dargestellt und werden anhand der Zeichnung näher beschrieben.

Fig.1 erläutert das Prinzip des "marginal voltage measurement"-Verfahrens nach dem Stand der Technik.

Fig.2 zeigt ein Blockschaltbild für eine Vorrichtung zur Durchführung eines anhand von Fig.1 erläuterten Verfahrens nach dem Stand der Technik.

Fig.3 zeigt das Ergebnis eines anhand von Fig.1 erläuterten Verfahrens nach dem Stand der Technik.

Fig.4 erläutert ein Verfahren nach dem Stand der Technik.

Fig.5 erläutert ein Verfahren nach der Erfindung.

Fig.6 zeigt ein Blockschaltbild für eine Vorrichtung nach der Erfindung.

Fig.7 erläutert ein Verfahren nach der Erfindung.

Zur Durchführung eines Verfahrens nach der Erfindung und zum Aufbau einer Vorrichtung nach der Erfindung kann ein Laser-Scanner verwendet werden, wie er in der US-PS 4407008 beschrieben ist.

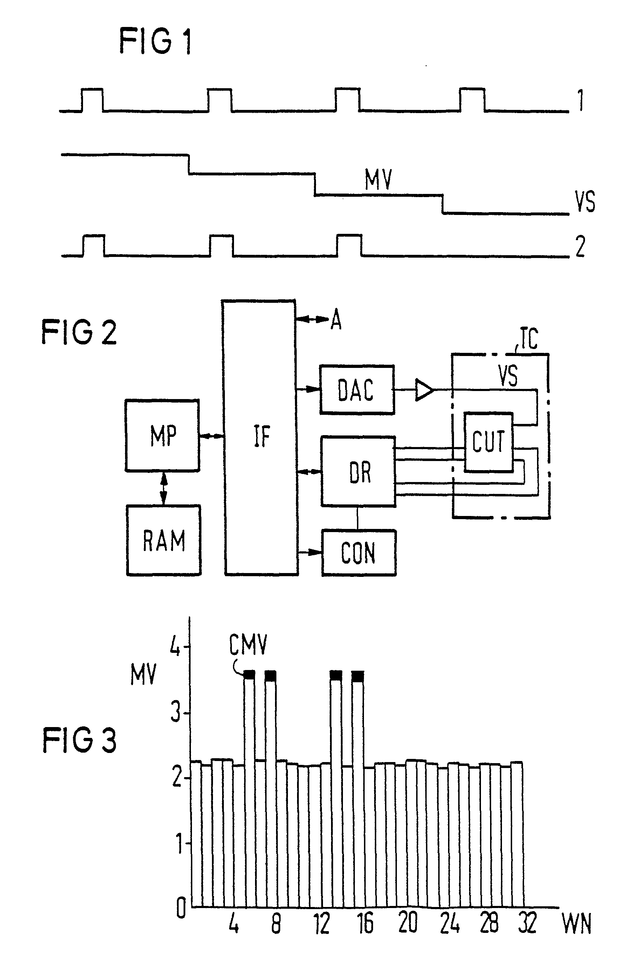

Fig.1 erläutert ein Verfahren für ein "marginal voltage measurement" nach dem Stand der Technik. Ein Eingang eines elektrischen Schaltkreises, dessen Funktion überprüft werden soll, wird mit einer periodisch sich wiederholenden pulsförmigen Spannung 1 angesteuert. Die Betriebsspannung VS des zu überprüfenden Schaltkreises wird nach jeder Periode der Spannung 1 um einen diskreten Wert abgesenkt. Solange die Betriebsspannung VS der zu überprüfenden elektrischen Schaltung größer oder gleich einem bestimmten Wert MV (marginal voltage) ist, zeigt ein Ausgang der zu überprüfenden Schaltung einen fehlerfreien Verlauf einer Ausgangsspannung 2. Bei der Darstellung des Verfahrens nach dem Stand der Technik in Fig.1 ist angenommen, daß die Ausgangssignalspannung 2 ebenfalls einen periodischen pulsförmigen Verlauf aufweisen soll, wenigstens solange, wie der Verlauf der Ausgangsspannung 2 fehlerfrei ist. Wenn die Betriebsspannung VS unterhalb des bestimmten Wertes MV abgesenkt wird, tritt in der Funktion der zu überprüfenden elektrischen Schaltung ein Fehler auf. Dieser Fehler in der Funktion der elektrischen Schaltung läßt sich am Verlauf der Ausgangssignalspannung 2 nachweisen, weil in dem Fall, in dem die Betriebsspannung VS einen Wert kleiner als den Wert MV aufweist, die Ausgangssi gnalspannung 2 einen fehlerhaften Verlauf zeigt.

Das Konzept einer Grenzspannung (marginal voltage) für die Betriebsspannung VS, bei der eine zu überprüfende elektrische Schaltung gerade noch funktioniert, läßt sich sowohl bei kombinatorischen als auch bei sequentiellen Schaltwerken anwenden.

Wenn die Betriebsspannung VS nur zu solchen Zeiten abgesenkt ist, zu denen eine Eingangsspannung 1 gerade keine Spannungsänderung erfährt, kann derjenige Wert MV für die Mindestspannung der Betriebsspannung VS ermittelt werden, der notwendig ist, um einen gerade vorhandenen logischen Zustand fehlerfrei zu erhalten. Wenn die Betriebsspannung VS zu einem Zeitpunkt abgesenkt ist, zu dem eine Eingangsspannung 1 eine Spannungsänderung erfährt, kann derjenige Wert MV für die Mindestspannung der Betriebsspannung VS ermittelt werden, der notwendig ist, damit logische Zustandsänderungen fehlerfrei ablaufen können.

Es lassen sich im Prinzip drei verschiedene Werte MV für die Mindestspannung der Betriebsspannung VS angeben:

- ein "permanenter" Wert MV, bei dem gerade noch fehlerfreie Daten innerhalb von sequentiellen Schaltkreisen wie z.B. innerhalb von Speichern und innerhalb von Schieberegistern erhalten bleiben,

- ein "dynamischer" Wert MV, bei dem gerade noch dynamische Spannungsänderungen fehlerfrei ablaufen, und

- ein "unmittelbarer" Wert MV, unterhalb dessen in einem kombinatorischen Schaltkreis logische Fehler auftreten, die unmittelbar und direkt mit Signalwerten an einem Ausgang der elektrischen Schaltung verknüpft sind.

Fig.2 zeigt eine Vorrichtung zur Durchführung eines Verfah rens nach dem Stand der Technik, so wie es anhand der Fig.1 erläutert worden ist. Der Testablauf wird von einem Mikroprozessor MP kontrolliert. In einem Schreib-Lese-Speicher RAM, der an den Mikroprozessor MP angeschlossen ist, ist für jeden zu überprüfenden elektrischen Schaltkreis CUT ein Testprogramm enthalten. In diesem Speicher RAM können schließlich auch die Testergebnisse abgelegt werden. In diesem Speicher RAM kann auch noch eine Steuer-Software zur Aufbereitung des Testprogrammes in eine für den Mikroprozessor MP geeignete Form enthalten sein. Das Testprogramm bestimmt die Folge von logischen Eingangszuständen an den Eingängen des elekrischen Schaltkreises CUT. Das Testprogramm setzt über die Eingangs-/Ausgangs-Schnittstelle IF den bidirektionalen Treiber DR in den erforderlichen Betriebszustand. Über den Treiber DR werden Signale an die Eingänge der elektrischen Schaltung CUT abgegeben und werden Signale von den Ausgängen der elektrischen Schaltung CUT übernommen. Die Versorgungs- und Lastschaltkreise, die die logischen Signalpegel an den Eingängen und Ausgängen der elektrischen Schaltung CUT bestimmen, sind entlang der elektrischen Schaltung CUT auf einer universell verwendbaren Testkarte TC befestigt. Die Testkarte TC besitzt Stecker, auf die die elektrische Schaltung CUT aufgesteckt wird.

Die veränderliche Betriebsspannung VS wird über einen 12-Bit-Digital-/Analog-Wandler erzeugt. Die veränderliche Betriebsspannung VS wird vom Mikroprozessor MP gesteuert. Die aufeinanderfolgenden Werte der Betriebsspannung VS werden in Abhängigkeit von den vorhergehenden Testergebnissen bestimmt.

Über eine Steuereinrichtung CON wird die Richtung der Daten im Treiber DR gesteuert. Die Testergebnisse können über einen Ausgang A der Schnittstelle IF an einen Drucker oder an ein sonstiges Ausgabegerät ausgegeben werden.

Fig.3 erläutert die Änderung CMV in der Mindestspannung (marginal voltage), wenn ein Lichtstrahl eine Schwachstelle innerhalb der elektrischen Schaltung CUT trifft. Wenn ein 2-Bit-Addierer fünf Eingänge hat, besitzt er 32 verschiedene Werte für den oben näher beschriebenen Wert MV der "unmittelbaren" Mindestspannung (marginal voltage). Die 32 verschiedenen Werte sind in Fig.3 als Wortnummer WN angegeben. Bei den Wortnummern 6,8,14 und 16 ergeben sich anomale Werte MV für die Mindestspannung. Während ein Lichtstrahl die kombinatorische Schaltung abrastert, ist ein solches binäres Wort an die Eingänge der kombinatorischen Schaltung statisch angelegt, das einem der vier anomalen Werte MV für die Mindestspannung entspricht. Wenn der Lichtstrahl nun diejenige Schwachstelle trifft, die die anomalen Werte MV verursacht, werden photoneninduzierte Ladungsträger in der Umgebung der Schwachstelle erzeugt und verursachen eine kleine Änderung in der elektrischen Charakteristik der kombinatorischen Schaltung. Dadurch wird eine kleine Änderung CMV bei den anomalen Werten MV bewirkt. Auf diese Weise wird diejenige Schwachstelle lokalisiert, an der der technologische Defekt vorliegt.

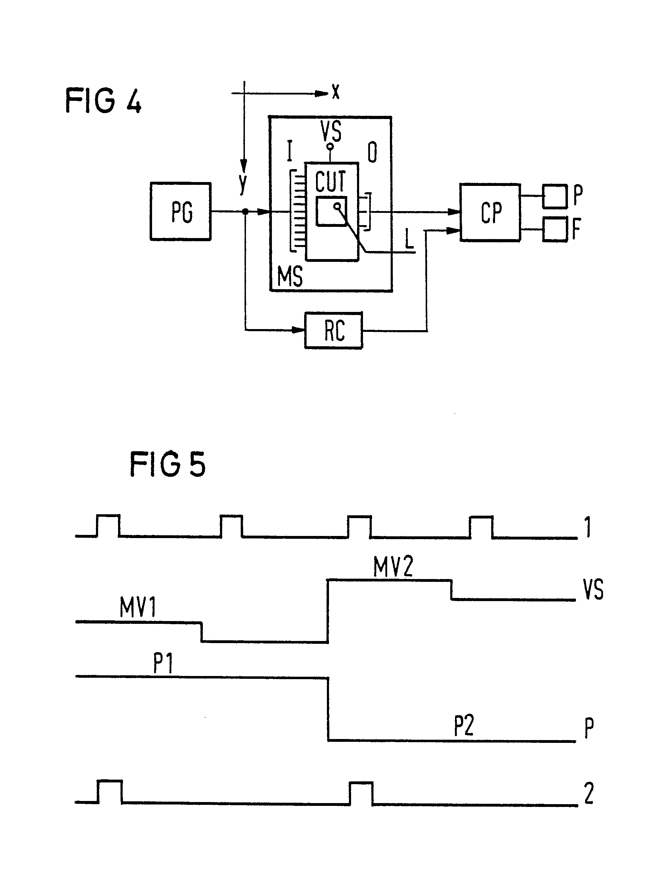

Fig.4 zeigt eine Vorrichtung zur Durchführung eines Verfahrens, wie es anhand der Fig.3 erläutert worden ist. Ein Generator PG erzeugt Prüfbit-Muster, die an die Eingänge I einer zu überprüfenden Schaltung CUT und an die Eingänge eines Referenzschaltkreises RC angelegt werden. Die Signale von den Ausgängen O der zu überprüfenden Schaltung CUT und die Signale von den Ausgängen des Referenzschaltkreises RC gelangen zu einem Komparator CP, in dem die Ausgangssignale der zu überprüfenden Schaltung CUT mit den Ausgangssignalen des Referenzschaltkreises RC verglichen werden. Wenn die jeweiligen Ausgangssignale übereinstimmen, wird das Signal P aktiviert, wenn die jeweiligen Ausgangssignale nicht überein stimmen, wird das Ausgangssignal F aktiviert. Ein Lichtstrahl L kann auf jeden Punkt der zu überprüfenden Schaltung CUT positioniert werden. Die zu überprüfende Schaltung CUT wird mit der veränderlichen Betriebsspannung VS versorgt. Die zu überprüfende Schaltung CUT ist beispielsweise auf dem Tisch MS eines Laser-Rastermikroskops angeordnet.

In der Fig.4 ist der Test einer kombinatorischen Schaltung dargestellt. Der Test einer sequentiellen Schaltung erfolgt ähnlich. Wenn der Lichtstrahl L auf eine Schwachstelle innerhalb einer sequentiellen Schaltung trifft, wird die logische Funktion der sequentiellen Schaltung gestört.

In der Praxis treten oft mehrere Bereiche auf, die bei Auftreffen des Lichtstrahls anomale Werte MV einer Mindestspannung verursachen. Die anomalen Werte MV können dabei größer oder kleiner als die bei einem guten Schaltkreis zu erwartenden Werte MV sein. Diejenigen Bereiche, die alle auf das Auftreffen des Lichtstrahls L reagieren, sind praktisch immer in physikalischer und elektrischer Verbindung mit den wahren Schwachstellen. Da die Stärke der Änderung CMV der Mindestspannung von der Natur der Schwachstelle abhängt, kann die wahre Schwachstelle dadurch herausgefunden werden, daß der Lichtstrahl L so stark wie möglich fokussiert wird. Die wahre Schwachstelle liegt dort, wo die Änderung CMV im Wert der Mindestspannung am größten ist.

Eine Vorrichtung nach Fig.4 kann ohne weiteres automatisiert werden. Die verschiedenen Werte MV für die Mindestspannung können an jedem Rasterpunkt innerhalb der zu überprüfenden Schaltung CUT gemessen werden. Das Abrastern der zu überprüfenden elektrischen Schaltung CUT mit dem Lichtstrahl L, die Veränderung der Betriebsspannung VS, die Eingabe von Si gnalen an die zu überprüfende elektrische Schaltung CUT und die Überprüfung von Ausgangssignalen dieser elektrischen Schaltung CUT können von einem Computer gesteuert werden.

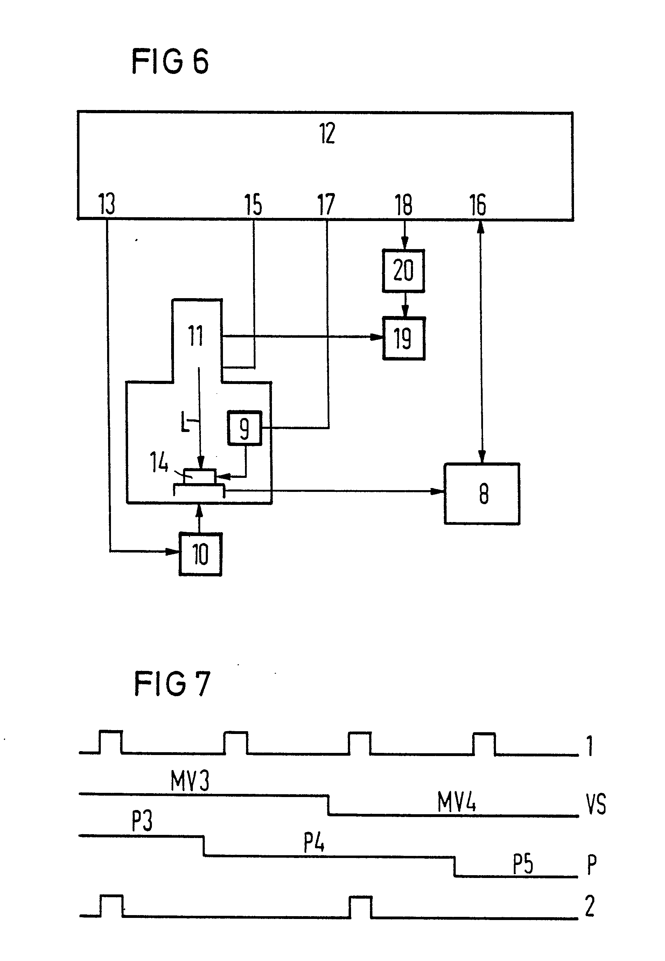

Fig.5 erläutert ein Verfahren nach der Erfindung. Bei einem Verfahren nach der Erfindung können nicht nur Fehlerstellen für bereits feststellbare Fehler innerhalb der Schaltung lokalisiert werden, wie dies anhand von Fig.3 erläutert worden ist. Bei einem Verfahren nach der Erfindung können auch solche Schwachstellen lokalisiert werden, die ohne Veränderung von äußeren Parametern noch nicht zu einem fehlerhaften Verhalten der zu überprüfenden elektrischen Schaltung Anlaß geben. Solche Schwachstellen können jedoch zu einem vorzeitigen Verlust der Funktiontüchtigkeit einer zu überprüfenden Schaltung führen. Solche Schwachstellen werden dadurch aufgedeckt, daß ein oder mehrere Parameter P während des Tests verändert werden. Solche Parameter P können die Wiederholrate von Signalpulsen, Abfall- und Anstiegszeit von Signalpulsen, Amplitude der Signalpulse, eine den Signalpulsen überlagerte Gleichspannung, eine Phase von Signalpulsen bezüglich der Signalfrequenz, die Temperatur bzw. die elektrische und/oder magnetische Feldstärke und eine auf die elektrische Schaltung gerichtete Strahlung sein.

Wenn im Beispiel nach Fig.5 ein Signal 1 an einem Eingang einer elektrischen Schaltung anliegt, und wenn die veränderlichen Parameter P solche Werte besitzen, die einem Parameter bzw. einer Parameterkombination P1 zugeordnet werden können, wenn gleichzeitig der Lichtstrahl L auf einen Abtastpunkt auftrifft und wenn dabei die Versorgungsspannung VS einen Wert MV1 aufweist, zeigt das Signal 2 an einem Ausgang der elektrischen Schaltung, daß die Funktion der elektrischen Schaltung fehlerfrei ist. Solange ein Wert P1 eines Parameters bzw. einer Parameterkombination vorhanden ist, genügt eine kleine Absenkung der Betriebsspannung VS unterhalb des Wertes MV1, daß die Funktion der elektrischen Schaltung nicht mehr einwandfrei ist, wie am Signal 2 abgelesen werden kann. Wenn nun der Wert eines Parameters bzw. einer Parameterkombination zum Wert P2 hin verändert wird, während am selben Eingang der elektrischen Schaltung wie beim gerade beschriebenen Beispiel das Signal 1 anliegt, und während der Lichtstrahl L auf denselben Abtastpunkt wie beim gerade beschriebenen Beispiel auftrifft, ist derjenige Wert der Betriebsspannung VS, bei dem die Schaltung gerade noch fehlerfrei funktioniert, vom Wert MV1 zum Wert MV2 hin verändert worden. Aus der Differenz zwischen den Werten MV1 und MV2 läßt sich ablesen, wie stark die nähere Umgebung des gerade vom Lichtstrahl getroffenen Abtastpunktes auf eine Veränderung der kritischen Parameter P von der Wertekombination P1 zur Wertekombination P2 reagiert. Daraus lassen sich Rückschlüsse auf technologische Schwachstellen im näheren Bereich des vom Lichtstrahl L getroffenen Abtastpunktes ziehen. Je nach Änderung des Parameters bzw. der Parameterkombination P kann der Wert MV2 größer, kleiner oder gleich dem Wert MV1 sein. Eine kleine Absenkung der Betriebsspannung VS bei vorliegendem Parameter bzw. bei vorliegender Parameterkombination P2 unterhalb des Wertes MV2 führt wiederum dazu, daß die elektrische Schaltung nicht mehr einwandfrei funktioniert, wie am Ausgangssignal 2 abgelesen werden kann.

Technologische Schwachstellen, die mit einem solchen Verfahren geortet werden können, sind beispielsweise Leckstromkanäle, ungewollte Kapazitäten, Grenzschichten, die auf Temperatur oder auf elektrische oder auf magnetische Felder ungewollt stark reagieren, strahlungsempfindliche Bereiche, Stellen mit ungewollten Werten für den elektrischen Widerstand u.s.w.

Fig.6 zeigt eine Vorrichtung zur Durchführung eines Verfahrens nach Fig.5. Der Ablauf des Verfahrens wird von einem Rechner 12 (Interdata 6/16) gesteuert. Die Positionierung des Lichtstrahls L erfolgt in einem Laser-Scanner nach der US-Patentschrift 4407008 mit Hilfe eines digitalen Rastergenerators 15. Die Ansteuerung eines als zu überprüfende elektrische Schaltung 14 verwendeten Mikroprozessors 8085 erfolgt durch ein Mikroprozessor-Laboratorium 10 (HP μ-Lab 5036 A). Die Modulation der über die Ansteuerung 10 veränderbaren Parameter - wie beispielsweise Wiederholrate, Abfall- und Anstiegszeit, Amplitude, überlagerte Gleichspannung und Phase bei pulsförmigen Signalen - erfolgt über den Ausgang 13 des Rechners 12. Die Modulation der nicht über die Ansteuerung 10 veränderbaren Parameter - wie beispielsweise Temperatur, elektrische und/oder magnetische Feldstärke, Strahlung u.s.w. - erfolgt über eine Einrichtung bzw. über Einrichtungen 9, die über den Ausgang 17 vom Rechner 12 gesteuert wird bzw. gesteuert werden. Einrichtungen 9, die dafür geeignet sind, sind dem Fachmann wohlbekannt. Die Ausgangssignale der elektrischen Schaltung 14 gelangen zu einer Einrichtung 8, in der die Ausgangssignale bewertet werden. Die Einrichtung 8 kann beispielsweise ein Logikanalysator Biomation K100 sein. Über den Ausgang 16 des Rechners 12 wird dabei die Meßwert-Verarbeitung im Logikanalysator 8 gesteuert. Die Meßergebnisse können jedoch auch direkt in den für die Ablaufsteuerung verwendeten Rechner eingespeichert und dort ausgewertet werden. Die Meßergebnisse können auch in einem anderen Rechner gespeichert werden.

Bei jedem Abtastpunkt der elektrischen Schaltung 14, auf den der Lichtstrahl L auftrifft, wird wenigstens ein kritischer Parameter P moduliert. Beispielsweise wird ein Parameter P von einem Wert P1 zu einem Wert P2 verändert. Dabei wird die Differenz zwischen den Werten MV1 und MV2 der Betriebsspannung VS, wie anhand von Fig.5 erläutert, gemessen. Diese Differenz zwischen den Werten MV1 und MV2 wird im Logikanalysator 8 oder im Rechner 12 bewertet. Das Ergebnis dieser Bewertung wird dazu benutzt, ein dem Ergebnis dieser Bewertung entsprechendes Bildmuster auf dem Bildschirm 19 über den Ausgang 18 des Rechners 12 zu erzeugen und dieses Bildmuster, das die technologischen Schwachstellen in der elektrischen Schaltung 14 anzeigt, einem mit Hilfe des LaserScanners 11 gewonnenen Bild der elektrischen Schaltung 14 zu überlagern. Auf diese Weise kann die Lage einer fehlerhaften Stelle in der elektrischen Schaltung 14 lokalisiert werden. Zwischen dem Ausgang 18 des Rechners 12 und dem Bildschirm 19 kann ein Video-Verstärker 20 geschaltet sein.

Fig.7 erläutert ein weiteres Ausführungsbeispiel für ein Verfahren nach der Erfindung. Wiederum liegt das Signal 1 an einem Eingang der elektrischen Schaltung 14 an. Die Betriebsspannung VS wird zunächst auf einen Wert MV3 eingestellt. Während die Betriebsspannung konstantgehalten wird, wird ein Parameter bzw. eine Parameterkombination P auf einen Wert P3 eingestellt. Dieser Parameter bzw. diese Parameterkombination P3 erlaubt in Verbindung mit dem Wert MV3 der Betriebsspannung VS eine fehlerfreie Funktion der elektrischen Schaltung 14, was am Ausgangssignal 2 ersichtlich ist. Während der Wert MV3 der Beriebsspannung VS konstantgehalten wird, wird nunmehr der Parameter bzw. die Parameterkombination auf den Wert P4 eingestellt. Sofort bricht die Funktionsfähigkeit der elektrischen Schaltung 14 zusammen, was am Ausgangssignal 2 zu erkennen ist. Nunmehr kann bei konstantem Parameter bzw. bei konstanter Parameterkombination P4 der Wert der Betriebsspannung VS vom Wert MV3 zum Wert MV4 hin verändert werden. Nach dem Beispiel von Fig.7 gewinnt dabei die elektrische Schaltung 14 wieder ihre Funktionsfähigkeit zurück, was wiederum am Ausgangssignal 2 erkannt werden kann. Wird nunmehr die Betriebsspannung VS auf dem Wert MV4 beibehalten und wird gleichzeitig der Parameter bzw. die Parameterkombination auf den Wert P5 eingestellt, so bricht im Beispiel nach Fig.7 die Funktionsfähigkeit der elektrischen Schaltung 14 wieder zusammen, was wiederum am Ausgangssignal 2 abgelesen werden kann.

Bei einem Beispiel nach Fig.7 kann entweder die gesamte elektrische Schaltung 14 abgerastert werden oder es können auch einige ausgewählte Punkte selektiv abgetastet werden. Auch bei einem Beispiel nach Fig.7 wird bei jedem Abtastpunkt die Funktion der elektrischen Schaltung 14 über das Ausgangssignal bewertet. Das Ergebnis dieser Bewertung kann wiederum in einem besonderen Ausführungsbeispiel einer mit Hilfe des Lichtstrahls L gewonnenen Abbildung von der elektrischen Schaltung 14 beispielsweise als farbiges Muster überlagert werden. Wenn beim Auftreffen des Lichtstrahls L auf einen fehlerfreien Abtastpunkt die elektrische Schaltung 14 funktionstüchtig bleibt, kann beispielsweise vorgesehen werden, daß dort, wo in der Abbildung auf dem Bildschirm 19 dieser Abtastpunkt abgebildet wird, kein Farbton überlagert wird. Wenn dagegen beim Auftreffen des Lichtstrahls L auf einen fehlerhaften Abtastpunkt die elektrische Schaltung 14 funktionsuntüchtig wird, kann je nach Schwere des Fehlers, die beispielsweise am Ausmaß der Veränderung des Parameters bzw. der Parameterkombination P, die erforderlich ist, damit die elektrische Schaltung 14 funktionsuntüchtig ist, abgelesen werden kann, ein verschieden abgestufter Grauton oder ein unterschiedlicher Farbton dort, wo auf dem Bildschirm 19 dieser Abtastpunkt abgebildet wird, überlagert werden.

Der Lichtstrahl L kann auch gepulst werden. Dies empfiehlt sich bei der Überprüfung einer empfindlichen elektri schen Schaltung, bei der bei einem längeren Verweilen des Lichtstrahls L auf einem Abtastpunkt soviele Ladungsträger freigesetzt werden würden, daß beim Abtasten eines jeden Abtastpunktes die elektrische Schaltung funktionsuntüchtig werden würde. Das Abtasten eines Abtastpunktes mit einem gepulsten Lichtstrahl L empfiehlt sich jedoch auch dann, wenn nur ein einziger oder mehrere Phasenpunkte bzw. Phasenbereiche innerhalb einer Periode des sich am Abtastpunkt wiederholenden Spannungsverlaufs kritisch sind, d.h. zu einem Ausfall der elektrischen Schaltung führen können. Beispielsweise kann bei einer sich periodisch wiederholenden pulsförmigen Spannung am Abtastpunkt eine Flanke eines Pulses kritisch sein, während das Pulsdach des zu der kritischen Flanke gehörenden Pulses nicht kritisch ist. Wenn der Abtastpunkt mit dem Lichtstrahl L stroboskopisch abgetastet wird, können kritische Phasen bzw. kritische Phasenbereiche innerhalb einer Periode des sich am Abtastpunkt wiederholenden Spannungsverlaufs ermittelt werden. Stroboskopisch wird ein Abtastpunkt dann abgetastet, wenn an diesem Abtastpunkt ein bestimmter Spannungsverlauf sich zeitlich wiederholt und wenn der auf den Abtastpunkt gerichtete Lichtstrahl L nur immer zu einer ganz bestimmten Phase innerhalb der Periode des sich am Abtastpunkt wiederholenden Spannungsverlaufs eingeschaltet wird. Ein solches stroboskopisches Verfahren mit einem Lichtstrahl L kann entsprechend einem aus der US-PS 3628012 bkannten stroboskopischen Verfahren mit einem Elektronenstrahl durchgeführt werden. Wenn mit Hilfe des stroboskopischen Meßverfahrens der sich am Abtastpunkt periodisch wiederholende Signalverlauf bei verschiedenen Phasen bezüglich der Periode des sich am Abtastpunkt wiederholenden Spannungsverlaufs abgetastet wird, kann in einem sog. Sampling-Verfahren die Phase bezüglich der Periode des sich am Abtastpunkt wiederholenden Signalverlaufs allmählich über die gesamte Periode dieses sich wiederholenden Signalverlaufs oder über Teilbereiche dieses sich wiederholenden Signalverlaufs geschoben werden. Auf diese Weise können kritische Phasen innerhalb einer Periode des sich am Abtastpunkt periodisch wiederholenden Signalverlaufs ermittelt werden. Ein solches Sampling-Verfahren mit dem Lichtstrahl L kann entsprechend einem Sampling-Verfahren durchgeführt werden, wie es für einen Elektronenstrahl in der US-PS 4220853 beschrieben ist.

Eine Einrichtung zum Pulsen des Lichtstrahls L ist in einem Laser-Scanner 11 enthalten, wie er in der US-PS 4407008 angegeben ist. Eine Synchronisation des gepulsten Lichtstrahls L mit dem am Abtastpunkt sich wiederholenden Spannungsverlauf kann über die beiden Ausgänge 13 und 15 des Rechners 12 erfolgen.

**Ansprüche**

1. Verfahren zur Fehlerlokalisierung in einer elektrischen Schaltung (14) mit einem Lichtstrahl (L),

- bei dem wenigstens ein Abtastpunkt innerhalb der elektrischen Schaltung (14) mit einem sich wiederholenden Spannungsverlauf angesteuert wird,

- bei dem der Lichtstrahl (L) auf wenigstens einen Abtastpunkt der elektrischen Schaltung (14) gerichtet wird,

- bei dem der Lichtstrahl (L) am Abtastpunkt durch Freisetzen von Ladungsträgern die Funktion der elektrischen Schaltung (14) stört,

- bei dem bei jedem Abtastpunkt die Spannung, mit der dieser Abtastpunkt angesteuert wird, verändert oder konstant gehalten wird, dadurch **gekennzeichnet,**

- daß bei jedem Abtasten eines jeden Abtastpunkts wenigstens eine einzige Periode des sich wiederholenden Spannungsverlaufs, mit dem dieser Abtastpunkt angesteuert wird, durchlaufen wird, und

- daß bei jedem Abtastpunkt wenigstens ein für eine bestimmte Spezifikation der elektrischen Schaltung (14) kritischer Parameter (P) moduliert wird, so lange, bis die elektrische Schaltung (14) funktionsuntüchtig ist.

2. Verfahren nach Anspruch 1, dadurch **gekennzeichnet,**daß der wenigstens eine kritische Parameter (P) während einer Wiederholung derjenigen Spannung, mit der der Abtastpunkt angesteuert wird, nicht verändert wird.

3. Verfahren nach Anspruch 1 oder 2, dadurch **gekennzeichnet,** daß zur Lokalisierung von Logikfehlern die Wiederholrate einer pulsförmigen Spannung am Abtastpunkt moduliert wird.

4. Verfahren nach einem der Ansprüche 1 bis 3, dadurch **gekennzeichnet,** daß zur Lokalisierung von Logikfehlern wenigstens eine Flanke eines Spannungspulses am Abtastpunkt moduliert wird.

5. Verfahren nach einem der Ansprüche 1 bis 4, dadurch **gekennzeichnet,** daß zur Lokalisierung von Logikfehlern die Amplitude der Spannung am Abtastpunkt moduliert wird.

6. Verfahren nach einem der Ansprüche 1 bis 5, dadurch **gekennzeichnet,** daß zur Lokalisierung von Logikfehlern eine Gleichspannung, die der Spannung am Abtastpunkt überlagert ist, moduliert wird.

7. Verfahren nach einem der Ansprüche 1 bis 6, dadurch **gekennzeichnet,** daß zur Lokalisierung von Logikfehlern die Phase eines Spannungspulses am Abtastpunkt moduliert wird.

8. Verfahren nach einem der Ansprüche 1 bis 7, dadurch **gekennzeichnet,** daß zur Lokalisierung von temperaturabhängigen Fehlern die Temperatur des Abtastpunkts moduliert wird.

9. Verfahren nach einem der Ansprüche 1 bis 8, dadurch **gekennzeichnet,** daß zur Lokalisierung von Fehlern, die in elektrischen Feldern auftreten, die elektrische Feldstärke am Abtastpunkt moduliert wird.

10. Verfahren nach einem der Ansprüche 1 bis 9, dadurch **gekennzeichnet,** daß zur Lokalisierung von Fehlern, die in magnetischen Feldern auftreten, die magnetische Feldstärke am Abtastpunkt moduliert wird.

11. Verfahren nach einem der Ansprüche 1 bis 10, dadurch **gekennzeichnet,** daß zur Lokalisierung von Gebieten, die empfindlich auf Strahlung reagieren, die Strahlung am Abtastpunkt moduliert wird.

12. Verfahren nach einem der Ansprüche 1 bis 11, dadurch **gekennzeichnet,** daß der Lichtstrahl (L) synchron mit dem sich an einem Abtastpunkt wiederholenden Spannungsverlauf gepulst wird.

13. Vorrichtung zur Fehlerlokalisierung in einer elektrischen Schaltung (14),

- mit einem Lichtstrahl (L) zum Abtasten wenigstens eines Abtastpunkts,

- mit einer Einrichtung (10,12) zur Ansteuerung der elektrischen Schaltung (14),

- mit einer Einrichtung (8,12) zur Bewertung des Ausgangssignals der elektrischen Schaltung (14),

**gekennzeichnet** durch eine Einrichtung (9, 10, 13, 17) zur Modulation wenigstens eines für eine bestimmte Spezifikation der elektrischen Schaltung (14) kritischen Parameters (P).

14. Vorrichtung nach Anspruch 13, **gekennzeichnet** durch eine Einrichtung (10, 13) zur Modulation der Wiederholrate einer pulsförmigen Spannung am Abtastpunkt.

15. Vorrichtung nach Anspruch 13 oder 14, **gekennzeichnet** durch eine Einrichtung (10, 13) zur Modulation wenigstens einer Flanke eines Spannungspulses am Abtastpunkt.

16. Vorrichtung nach einem der Ansprüche 13 bis 15, **gekennzeichnet** durch eine Einrichtung (10, 13) zur Modulation der Amplitude einer Spannung am Abtastpunkt.

17. Vorrichtung nach einem der Ansprüche 13 bis 16, **gekennzeichnet** durch eine Einrichtung (10, 13) zur Modulation des Gleichspannungspegels der Spannung am Abtastpunkt.

18. Vorrichtung nach einem der Ansprüche 13 bis 17, **gekennzeichnet** durch eine Einrichtung (10, 13) zur Modulation der Phase eines Spannungspulses am Abtastpunkt.

19. Vorrichtung nach einem der Ansprüche 13 bis 18, **gekennzeichnet** durch eine Einrichtung (9, 17) zur Modulation der Temperatur am Abtastpunkt.

20. Vorrichtung nach einem der Ansprüche 13 bis 19, **gekennzeichnet** durch eine Einrichtung (9, 17) zur Modulation der elektrischen Feldstärke am Abtastpunkt.

21. Vorrichtung nach einem der Ansprüche 13 bis 20, **gekennzeichnet** durch eine Einrichtung (9, 17) zur Modulation der magnetischen Feldstärke am Abtastpunkt.

22. Vorrichtung nach einem der Ansprüche 13 bis 21, **gekennzeichnet** durch eine Einrichtung (9, 17) zur Modulation wenigstens einer Strahlungsart am Abtastpunkt.

23. Vorrichtung nach einem der Ansprüche 13-22, **gekennzeichnet** durch eine Einrichtung zum Pulsen des Lichtstrahls (L).

## FIG 1

## FIG 2

## FIG 3

FIG 4

FIG 5

## FIG 6

## FIG 7

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X,D | MICROELECTRONICS AND RELIABILITY, Band 22, Nr. 2, 1982, Seiten 241-264, Oxford, GB; D.J. AGER u.a.: "The application of marginal voltage measurements to detect and locate defects in digital microcircuits" * Insgesamt * | 1,2,13 | G 01 R 31/28 G 01 R 31/30 |
| | --- | | |
| X | GB-A-2 069 152 (THE POST OFFICE) * Insgesamt * | 1,2,13 | |
| | ----- | | |

RECHERCHIERTE SACHGEBIETE (Int. Cl.4)

G 01 R

Der vorliegende Recherchenbericht wurde für alle Patentansprüche erstellt.

| Recherchenort | Abschlußdatum der Recherche | Prüfer |
|---|---|---|
| DEN HAAG | 16-12-1985 | KUSCHBERT D.E. |